# EUROPÄISCHE PATENTSCHRIFT

(11) **EP 3 305 045 B1**
(45) Veröffentlichungstag und Bekanntmachung des Hinweises auf die Patenterteilung: **23.12.2020**
(21) Anmeldenummer: 16722792.5
(22) Anmeldetag: 14.05.2016
(51) Int. Cl.: H05K 5/00

(54) **GEHÄUSE FÜR EINE ELEKTRONISCHE EINRICHTUNG**
HOUSING FOR AN ELECTRONIC DEVICE
BOÎTIER POUR UN DISPOSITIF ÉLECTRONIQUE

(30) Priorität: 27.05.2015 DE 102015006537; 08.06.2015 DE 102015007471
(43) Veröffentlichungstag der Anmeldung: 11.04.2018
(73) Patentinhaber: WABCO GmbH, 30453 Hannover (DE)
(72) Erfinder: GÖBEL, Jens, 30655 Hannover (DE); REHBEIN, Klaus, 31174 Schellerten (DE); WUSTRACK, Tobias, 30455 Hannover (DE)
(74) Vertreter: Copi, Joachim
(86) Internationale Anmeldenummer: PCT/EP2016/000804
(87) Internationale Veröffentlichungsnummer: WO 2016/188617

(56) Entgegenhaltungen:
- DE-A1- 10 211 803
- DE-A1-102011 016 506

## Beschreibung

Die Erfindung betrifft ein Gehäuse für eine elektronische Einrichtung gemäß dem Anspruch 1.

Zum Schutz vor äußeren Einflüssen, wie beispielsweise Feuchtigkeit und Verunreinigungen werden elektronische Einrichtungen, wie beispielsweise elektronische Geräte, Leiterplatten oder dergleichen abgedeckt bzw. von einem Gehäuse um- - schlossen. Bei diesen Gehäusen handelt es sich üblicherweise um Kunststoffverschalungen oder um Gehäuse aus Metall, wie beispielsweise Aluminium.

Nachdem der Herstellungsprozess der elektronischen Einrichtung bzw. die Bestückung der Leiterplatte abgeschlossen ist, wird diese durch ein Deckelteil verschlossen. Als Verbindungsmittel werden beispielsweise Schrauben, Nieten, Bolzen oder dergleichen verwendet. Bei der Verschraubung der Gehäuseteile bzw. bei der Vernietung oder dergleichen fallen Späne oder sonstige Partikel an, die im Inneren des Gehäuses auf die elektronische Einrichtung, insbesondere auf die Leiterplatte fallen können. Diese Späne bzw. diese Teile können dann zu Kurzschlüssen oder anderen Fehlfunktionen der Einrichtung oder der Leiterplatte führen. Des Weiteren besteht eine Gefahr darin, dass Späne auf eine Dichtfläche eines Gehäuseteils fällt und die Dichtung des Gehäuses dadurch beschädigt wird.

Einschub zum Stand der Technik

DE 10 2011 016 506 A1 offenbar ein wasserfestes elektronisches Gerät und Montageverfahren desselben.

Aus dem Stand der Technik sind Gehäuse für elektronische Einrichtungen bekannt, bei denen die Gehäuseteile durch Verbindungsmittel, insbesondere Schrauben, außerhalb des Gehäuses verschraubt werden. Eine Verunreinigung der elektronischen Einrichtung bzw. der Leitplatte oder der das Gehäuse schließenden Dichtung kann so vermieden werden. Allerdings lässt es sich bei manchen Anwendungen bzw. manchen Bauformen von elektronischen Einrichtungen nicht vermeiden, dass die Verschraubung des Gehäuses im Gehäuse erfolgen muss Z Ein weiteres Beispiel ist aus DE10211803 A1 vorbekannt.

Der Erfindung liegt daher die Aufgabe zugrunde, ein Gehäuse für ein elektronisches Gerät zu schaffen, dass einfach und zuverlässig verschraubbar ist, ohne dass die elektronische Einrichtung dadurch beeinflusst wird.

Ein Gehäuse zur Lösung dieser Aufgabe weist die Merkmale des Anspruchs 1 auf. Weitere Ausführungsbeispiele sind aus den abhängigen Ansprüchen bekannt. Demnach weist ein Gehäuse für eine elektronische Einrichtung, insbesondere für eine Leiterplatte, eine die Einrichtung aufweisende Grundplatte auf und ein Gehäuseteil, welches oberhalb der Grundplatte angeordnet ist. Des Weiteren weist das Gehäuse einen Gehäusedeckel auf, der die Einrichtung wenigstens teilweise abdeckt. Die Grundplatte, welche die Einrichtung aufweist, ist mit dem Gehäuseteil durch mindestens ein Verbindungsmittel und mindestens eine dem Verbindungsmittel entsprechende Bohrung verbindbar, wobei oberhalb der mindestens einen Bohrung, in der die Einrichtung aufweisenden Grundplatte, ein Schutzzylinder angeordnet ist. Der Innendurchmesser des Schutzzylinders korrespondiert mit dem Durchmesser der Bohrung, bzw. ist mindestens genau so groß wie der Durchmesser der Bohrung. Die elektronische Einrichtung bzw. die Leiterplatte kann entweder der Grundplatte zugeordnet sein, oder diese selbst bilden. So ist es beispielsweise denkbar, dass die Grundplatte durch die Leiterplatte gebildet wird und sich die Bohrungen in der Leiterplatte befinden.

Weiterhin sieht die Erfindung vor, dass der mindestens eine Schutzzylinder dem Gehäuseteil zugeordnet ist, so dass der mindestens eine Schutzzylinder in dem Gehäuseteil integriert ist und der Schutzzylinder als Hohlzylinder ausgebildet ist. Dadurch, dass der Schutzzylinder ein integraler Bestandteil des Gehäuseteils ist, wird eine besondere Kompaktheit des Gehäuses hergestellt und vermieden, dass einzelne Teile verloren gehen. Erfindungsgemäß kann es vorgesehen sein, dass sich der Schutzzylinder über die gesamte Höhe des Gehäuseteils bzw. des Gehäuses erstreckt und eine obere freie Öffnung aufweist, die einen direkten Zugang zu der Bohrung auf der Grundplatte bzw. auf der Leiterplatte ermöglicht.

Weiterhin wird vorgesehen, dass in dem Innenraum des Schutzzylinders eine Hülse angeordnet ist, deren Innendurchmesser mindestens dem Durchmesser der Bohrung entspricht. Diese Hülse ist erfindungsgemäß durch mindestens einen Vorsprung, insbesondere einen radial umlaufenden Vorsprung mit einer Innenwandung des Schutzzylinders verbunden, vorzugsweise fest verbunden. Dadurch bildet die Hülse eine ringartige Verjüngung innerhalb des Schutzzylinders, die entlang einer Längsachse des Schutzzylinders mit diesem in einer festen relativen Beziehung steht. Es ist jedoch alternativ auch denkbar, dass der Innenwandung des Schutzzylinders anstelle einer Hülse lediglich Vorsprünge oder dergleichen zugeordnet sind. Die Dimensionierung der Hülse bzw. des Schutzzylinders kann je nach Anforderung variieren. Auch der Innendurchmesser der Hülse korrespondiert mit dem Durchmesser der Bohrung, bzw. ist mindestens gleich dem der Bohrung.

Erfindungsgemäß ist vorgesehen, dass der Vorsprung der Hülse eine Auflagefläche gegenüber einer Innenwandung des Schutzzylinders ausbildet und diese Auflagefläche vorzugsweise angeschrägt ist. Durch diese Anschrägung des Vorsprungs bildet die Hülse innerhalb des Schutzzylinders eine Art Trichter, der zur Mitte der Bohrung gerichtet ist.

Die Erfindung sieht es des Weiteren vor, dass es sich bei den Verbindungsmitteln um Schrauben, Nieten, Stifte, Bolzen oder dergleichen handelt. Des Weiteren ist die Bohrung vorzugsweise als Gewindebohrung ausgebildet. Zur Verbindung des Gehäuseteils mit der Grundplatte ist somit erfindungsgemäß die mindestens eine Schraube durch den Schutzzylinder und die Hülse steckbar und in der Gewindebohrung der Grundplatte verschraubbar. Insbesondere ist die Schraube gegen die Auflagefläche der Hülse verschraubbar. Durch die Anschrägung des Vorsprungs der Hülse wird das Verbindungsmittel bzw. die Schraube direkt in die Bohrung bzw. Gewindebohrung geleitet. Dies stellt eine besondere Erleichterung der Verbindung dar, da die Verbindungsmittel lediglich in die größere Öffnung der Schutzzylinder gesteckt werden müssen. Darüber hinaus ist es sofort erkennbar, falls ein Verbindungsmittel bzw. eine Schraube nicht richtig mit der Gewindebohrung verbunden ist.

Durch die Herstellung einer Verbindung zwischen dem Gehäuseteil und der Grundplatte mit einem Verbindungsmittel innerhalb des Schutzzylinders werden bei dem Verbindungsprozess anfallende Partikel von dem Innenraum des Gehäuses bzw. von der elektronischen Einrichtung oder der Leiterplatte ferngehalten. Eine ungewollte Verschmutzung wird somit vermieden. Wenn das Gehäuseteil beispielsweise mit der Grundplatte durch Schrauben verschraubt wird, so verbleiben die anfallenden Späne innerhalb des Schutzzylinders und werden gegenüber dem Inneren des Gehäuses und der Dichtung ferngehalten. Neben einer Vereinfachung der Verbindung der einzelnen Teile bietet der Schutzzylinder somit den Vorteil, dass anfallende Partikel, wie beispielsweise Späne, von der elektronischen Einrichtung bzw. Leiterplatte sowie von der Dichtung ferngehalten werden.

Eine weitere Ausführungsmöglichkeit der vorliegenden Erfindung kann es vorsehen, dass der Schutzzylinder durch eine Dichtung, durch eine Versiegelung oder durch den Gehäusedeckel abdeckbar ist. Sobald das Gehäuseteil mit der Grundplatte verschraubt ist, wird der Schutzzylinder abgedeckt. Dies kann beispielsweise durch einen O-Ring oder eine Verklebung erfolgen. Es ist jedoch auch denkbar, dass der Deckel des Gehäuses auch die Öffnungen der Schutzzylinder abdeckt. Der Gehäusedeckel wird mit entsprechenden Dichtungsmitteln bzw. Schließmitteln auf das Gehäuseteil aufgesetzt und gegebenenfalls verklebt. Durch dieses Aufsetzen erfolgt eine dichte und vorzugsweise wieder lösbare Verbindung zwischen dem Deckel und dem Gehäuseteil.

Erfindungsgemäß sind dem Gehäuseteil mehrere Hülsen aufweisende Schutzzylinder zugeordnet. Vorzugsweise sind jeder Ecke des Gehäuseteils Schutzzylinder mit entsprechenden Hülsen zugeordnet. Insbesondere ist jeder Bohrung in der Grundplatte bzw. der Leiterplatte ein Schutzzylinder mit der entsprechenden Hülse zugeordnet.

Die Erfindung sieht es weiter vor, dass die Grundplatte und/oder das Gehäuseteil und/oder der Gehäusedeckel eine umlaufende Dichtlippe oder eine Dichtungsnut aufweist, um die Grundplatte mit dem Gehäuseteil und/oder das Gehäuseteil mit dem Deckelteil zu verbinden, insbesondere zu verschließen oder zu verkleben. Je nach Anforderung an die elektronische Einrichtung kann diese Dichtung lediglich einer Verschmutzung durch Staub dienen oder dicht gegenüber jeglichen Fluiden und/oder Gasen sein.

Bevorzugte Ausführungsbeispiele werden nachfolgend anhand der Zeichnung näher beschrieben. In dieser zeigen:
- Fig. 1: ein Gehäuseteil vordem Zusammenschrauben, und
- Fig. 2: ein Schnitt durch ein verschlossenes Gehäuse.

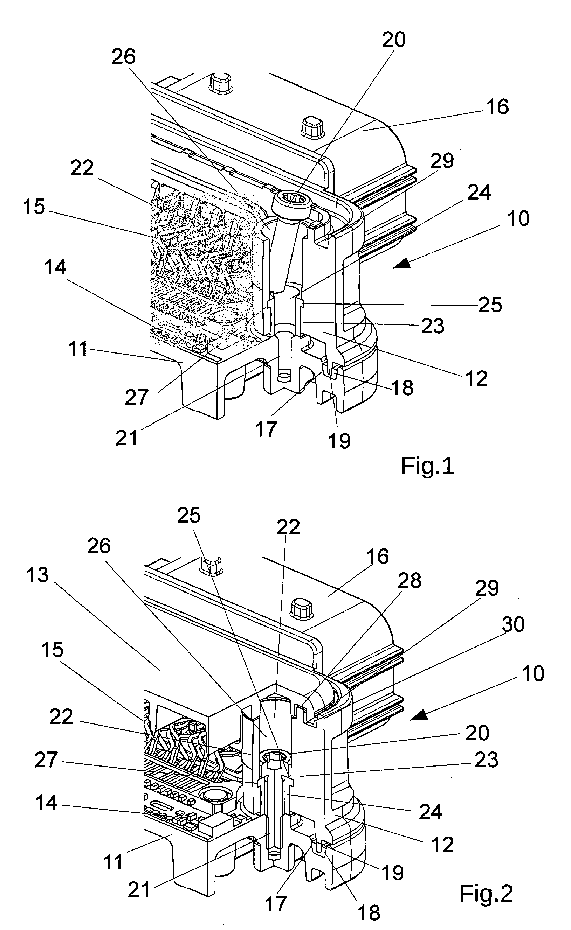

Das in den Fig. 1 und 2 dargestellte Ausführungsbeispiel des erfindungsgemäßen Gehäuses 10 setzt sich zusammen aus einer Grundplatte 11, einem Gehäuseteil 12 sowie einem Gehäusedeckel 13. In dem Gehäuse 10 ist eine elektronische Einrichtung oder eine Leiterplatte 14 oder dergleichen angeordnet. Bei dem in den Fig. 1 und 2 dargestellten Ausführungsbeispiel ist die Grundplatte 11 als Leiterplatte 14 bzw. die Leiterplatte 14 als Grundplatte 11 ausgebildet. Es ist jedoch auch denkbar, dass die elektronische Einrichtung, wie beispielsweise eine Leiterplatte der Grundplatte 11 einzeln zugeordnet ist.

Die Leiterplatte 14 kann beispielsweise durch eine Vielzahl von Leitern 15 mit einer Steckerbuchse 16 für eine externe Verbindung elektrisch verbunden sein.

Zum Abdecken der Leiterplatte 14 bzw. zum Schließen des Gehäuses 10 wird das Gehäuseteil 12 auf die Grundplatte 11 gesetzt. Für eine passgenaue und abdichtende Verbindung ist der Grundplatte 11 eine Nut 17 zugeordnet, in der sich vorzugsweise ein Dichtmittel 18 befinden kann. Bei diesem Dichtmittel 18 kann es sich beispielsweise um eine Dichtung oder dergleichen handeln. In dieses Dichtmittel 18 bzw. in die Nut 17 greift ein Steg 19 des Gehäuseteils 12. Vorzugsweise verläuft die Nut 17 um die gesamte Grundplatte 11, so dass zu allen Seiten hin eine dichtende Verbindung zwischen der Leiterplatte 14 und dem Gehäuseteil 12 hergestellt werden kann.

Um die Leiterplatte 14 fest mit dem Gehäuseteil 12 zu verbinden, wird das Gehäuseteil 12 in dem hier dargestellten Ausführungsbeispiel mit der Leiterplatte 14 durch eine Schraube 20 verschraubt. Es ist jedoch auch denkbar, dass das Gehäuseteil 12 mit der Leiterplatte 14 durch ein anderes Verbindungsmittel, wie beispielsweise einer Niete oder einen Bolzen oder dergleichen verbunden wird. Für das Verschrauben des Gehäuseteils 12 mit der Leiterplatte 14 weist diese eine Bohrung 21, insbesondere eine Gewindebohrung auf. Bei dieser Bohrung 21 kann es sich um durchgehendes Loch in der Leiterplatte 14 oder um ein Sackloch handeln.

Korrespondierend zu der Position der Bohrung 21 auf der Leiterplatte 14 ist dem Gehäuseteil 12 ein Schutzzylinder 22 integral zugeordnet. Dieser Schutzzylinder 22 ist als Hohlzylinder ausgebildet und erstreckt sich über die gesamte Höhe des Gehäuseteils 12. Sein innerer Durchmesser korrespondiert mit dem Durchmesser der Gewindebohrung bzw. ist leicht gegenüber diesem vergrößert.

Einem unteren Abschnitt 23 des Schutzzylinders 22 ist eine zylindrische Hülse 24 zugeordnet. Diese Hülse 24 ist ebenfalls als Hohlzylinder ausgebildet, deren Innendurchmesser mit dem Durchmesser der Bohrung 21 korrespondiert, bzw. mit deren Durchmesser identisch ist. Die Hülse 24 weist an einem oberen Rand einen radial umlaufenden Vorsprung 25 auf, der in eine Nut 27 einer Innenwandung 26 des Schutzzylinders 22 hineinragt. Somit ist die Hülse 24 fest mit dem Schutzzylinder 22 verbunden.

Der Vorsprung 25 der Hülse 24 ist leicht abgeschrägt, so dass der Vorsprung 25 leicht trichterartig ausgebildet ist.

Zum Verschließen des Gehäuses wird das Gehäuseteil 12 derart auf die Leiterplatte 14 gesetzt, dass der Schutzzylinder 22 bzw. die Hülse 24 in Kontakt mit der Leiterplatte 14 tritt, insbesondere die Hülse 24 zumindest teilweise in die Bohrung 21 hineinragt.

Die Schraube 20 wird sodann in den Schutzzylinder 22 gefügt und durch den Vorsprung 25 in die Bohrung 21 geleitet und kann dort verschraubt werden. Durch die Abschirmung der Bohrung 21 durch den Schutzzylinder 22 können keine beim Verschrauben der Schraube 20 auftretenden Späne auf die Leiterplatte 14 oder die Dichtmittel 18, 30 fallen. Somit bietet der Schutzzylinder 22 sowohl einen Schutz für die Leiterplatte 14, als auch eine Montagehilfe für das Einfügen der Schraube 20 in die Bohrung 21.

Nachdem die Schraube 20 mit der Leiterplatte 14 verschraubt wurde, kann der Schutzzylinder 22 mit einer Dichtung, wie beispielsweise einem O-Ring oder einem Dichtmittel versehen werden, oder durch den Gehäusedeckel 13 abgedeckt werden (Fig. 2).

Zum Verschließen des Gehäuses 10 wird der Gehäusedeckel 13 mit einem umlaufenden Steg 28 in eine entsprechende Nut 29, die ein Dichtmittel 30 aufweist, positioniert. Das Gehäuse 10 ist somit dicht verschlossen und die Leiterplatte vor Verunreinigungen geschützt.

Erfindungsgemäß ist es vorgesehen, dass die Grundplatte 11 bzw. die Leiterplatte 14 mehrere Bohrungen 21 aufweist, denen jeweils ein Schutzzylinder 22 mit einer Hülse 24 zugeordnet sind.

Es sei darauf hingewiesen, dass sich das erfindungsgemäße Gehäuse nicht auf das in den Fig. 1 und 2 dargestellte Ausführungsbeispiel beschränkt, sondern vielmehr auch weitere Ausgestaltungen aufweisen kann.

## Patentansprüche

1. Gehäuse (10) für eine elektronische Einrichtung, insbesondere eine Leiterplatte (14) mit einer die Einrichtung aufweisenden Grundplatte (11) und einem Gehäuseteil (12), das oberhalb der Grundplatte (11) angeordnet ist und einem Gehäusedeckel (13), der die Einrichtung wenigstens teilweise abdeckt, wobei die Grundplatte (11), welche die Einrichtung aufweist, mit dem Gehäuseteil (12) durch mindestens ein Verbindungsmittel und mindestens einer dem Verbindungsmittel entsprechenden Bohrung (21) verbindbar ist und wobei oberhalb der mindestens einen Bohrung (21) in der die Einrichtung aufweisenden Grundplatte (11) ein Schutzzylinder (22) angeordnet ist, dessen Innendurchmesser mindestens genauso groß wie der Durchmesser der Bohrung (21) ist, wobei das Verbindungsmittel innerhalb des Gehäuses angeordnet ist,
wobei einem unteren Abschnitt (23) des Schutzzylinders (22) eine zylindrische Hülse (24) zugeordnet ist, welche Hülse (24) ebenfalls als Hohlzylinder ausgebildet ist, deren Innendurchmesser mit dem Durchmesser der Bohrung (21) korrespondiert, bzw. mit deren Durchmesser identisch ist,
wobei die Hülse (24) an einem oberen Rand einen radial umlaufenden Vorsprung (25) aufweist, der in eine Nut (27) einer Innenwandung (26) des Schutzzylinders (22) hineinragt, so dass die Hülse (24) fest mit dem Schutzzylinder (22) verbunden ist,
wobei der Vorsprung (25) der Hülse (24) leicht abgeschrägt ist, so dass der Vorsprung (25) leicht trichterartig ausgebildet ist.

2. Gehäuse (10) für eine elektronische Einrichtung nach Anspruch 1, **dadurch gekennzeichnet, dass** der mindestens eine Schutzzylinder (22) dem Gehäuseteil (12) zugeordnet ist, insbesondere dass der mindestens eine Schutzzylinder (22) in dem Gehäuseteil (12) integriert ist und der Schutzzylinder (22) als Hohlzylinder ausgebildet ist.

3. Gehäuse (10) für eine elektronische Einrichtung nach einem der vorhergehenden Ansprüche, **dadurch gekennzeichnet, dass** der Vorsprung (25) der Hülse (24) eine Auflagefläche gegenüber einer Innenwandung (26) des Schutzzylinders (22) ausbildet und diese Auflagefläche vorzugsweise angeschrägt ist.

4. Gehäuse (10) für eine elektronische Einrichtung nach einem der vorhergehenden Ansprüche, **dadurch gekennzeichnet, dass** die Verbindungsmittel Schrauben (20), insbesondere Nieten, Stifte, Bolzen oder dergleichen, sind, die mit der Bohrung (21), vorzugsweise mit einer Gewindebohrung, verschraubbar sind.

5. Gehäuse (10) für eine elektronische Einrichtung nach einem der vorhergehenden Ansprüche, **dadurch gekennzeichnet, dass** zur Verbindung des Gehäuseteils (12) mit der Grundplatte (11) die mindestens eine Schraube (20) durch den Schutzzylinder (22) und die Hülse (24) steckbar ist und in der Bohrung (21) der Grundplatte (11) verschraubbar ist, insbesondere die Schraube (20) gegen die Auflagefläche der Hülse (24) verschraubbar ist.

6. Gehäuse (10) für eine elektronische Einrichtung nach einem der vorhergehenden Ansprüche, **dadurch gekennzeichnet, dass** der Schutzzylinder (22) durch eine Dichtung, durch eine Versiegelung oder durch den Gehäusedeckel (13) abdeckbar ist.

7. Gehäuse (10) für eine elektronische Einrichtung nach einem der vorhergehenden Ansprüche, **dadurch gekennzeichnet, dass** dem Gehäuseteil (12) mehrere Hülsen (24) aufweisende Schutzzylinder (22) zugeordnet sind, vorzugsweise jeder Ecke des Gehäuseteils (12) ein Schutzzylinder (22) mit einer Hülse (24) zugeordnet ist.

8. Gehäuse (10) für eine elektronische Einrichtung nach einem der vorhergehenden Ansprüche, **dadurch gekennzeichnet, dass** die Grundplatte (11) und/oder das Gehäuseteil (12) und/oder der Gehäusedeckel (13) einen umlaufenden Steg (19, 28) und/oder eine Dichtungsnut (18, 29) aufweist, um die Grundplatte (11) mit dem Gehäuseteil (12) und/oder das Gehäuseteil (12) mit dem Gehäusedeckel (13) zu verbinden, insbesondere zu verschließen.

## Claims

1. Housing (10) for an electronic device, in particular a circuit board (14), having a base plate (11), which has the device, and having a housing part (12), which is arranged above the base plate (11), and having a housing cover (13), which at least partially covers the device, wherein the base plate (11) which the device has is able to be connected to the housing part (12) by way of at least one connecting means and at least one bore (21) which corresponds to the connecting means, and wherein, above the at least one bore (21) in the base plate (11) having the device, there is arranged a protective cylinder (22), whose inner diameter is at least as large as the diameter of the bore (21), wherein the connecting means is arranged within the housing,
wherein a cylindrical sleeve (24) is assigned to a lower portion (23) of the protective cylinder (22), which sleeve (24) is also in the form of a hollow cylinder, whose inner diameter corresponds to the diameter of the bore (21) or is identical to the diameter thereof,
wherein the sleeve (24) has at an upper edge a radially peripheral projection (25) which projects into a groove (27) of an inner wall (26) of the protective cylinder (22) such that the sleeve (24) is connected fixedly to the protective cylinder (22), wherein the projection (25) of the sleeve (24) is slightly bevelled such that the projection (25) is formed in a slightly funnel-like manner.

2. Housing (10) for an electronic device according to Claim 1, **characterized in that** the at least one protective cylinder (22) is assigned to the housing part (12), in particular **in that** the at least one protective cylinder (22) is integrated in the housing part (12) and the protective cylinder (22) is in the form of a hollow cylinder.

3. Housing (10) for an electronic device according to either of the preceding claims, **characterized in that** the projection (25) of the sleeve (24) forms a support surface with respect to an inner wall (26) of the protective cylinder (22), and said support surface is preferably bevelled.

4. Housing (10) for an electronic device according to one of the preceding claims, **characterized in that** the connecting means are screws (20), in particular rivets, pins, bolts or the like, which are able to be screwed into the bore (21), preferably into a threaded bore.

5. Housing (10) for an electronic device according to one of the preceding claims, **characterized in that**, for connecting the housing part (12) to the base plate (11), the at least one screw (20) is able to be inserted through the protective cylinder (22) and the sleeve (24) and is able to be screwed into the bore (21) of the base plate (11), in particular the screw (20) is able to be screwed against the support surface of the sleeve (24).

6. Housing (10) for an electronic device according to one of the preceding claims, **characterized in that** the protective cylinder (22) is able to be covered by a gasket, by a seal or by the housing cover (13).

7. Housing (10) for an electronic device according to one of the preceding claims, **characterized in that** the housing part (12) is assigned multiple protective cylinders (22) having sleeves (24), each corner of the housing part (12) preferably being assigned a protective cylinder (22) having a sleeve (24) .

8. Housing (10) for an electronic device according to one of the preceding claims, **characterized in that** the base plate (11) and/or the housing part (12) and/or the housing cover (13) have/has a peripheral web (19, 28) and/or a seal groove (18, 29) in order for the base plate (11) to be connected to, in particular closed off by, the housing part (12) and/or for the housing part (12) to be connected to, in particular closed off by, the housing cover (13).

## Revendications

1. Boîtier (10) pour un dispositif électronique, en particulier une carte de circuits imprimés (14), comportant une plaque de base (11) comprenant le dispositif et une partie de boîtier (12) qui est disposée au-dessus de la plaque de base (11) et un couvercle de boîtier (13) qui recouvre au moins partiellement le dispositif, dans lequel la plaque de base (11), laquelle comprend le dispositif, peut être reliée à la partie de boîtier (12) par le biais d'au moins un moyen de liaison et d'au moins un alésage (21) correspondant au moyen de liaison, et dans lequel un cylindre de protection (22) est disposé au-dessus de l'au moins un alésage (21) dans la plaque de base (11) comprenant le dispositif, cylindre dont le diamètre intérieur est au moins aussi grand que le diamètre de l'alésage (21), dans lequel le moyen de liaison est disposé à l'intérieur du boîtier,
dans lequel une douille cylindrique (24) est associée à une partie inférieure (23) du cylindre de protection (22), laquelle douille (24) est également réalisée sous forme de cylindre creux dont le diamètre intérieur correspond au diamètre de l'alésage (21) ou est identique à son diamètre,
dans lequel la douille (24) comprend, au niveau d'un bord supérieur, une saillie (25) s'étendant radialement qui pénètre dans une rainure (27) d'une paroi intérieure (26) du cylindre de protection (22), de sorte que la douille (24) soit reliée solidement au cylindre de protection (22),
dans lequel la saillie (25) de la douille (24) est légèrement biseautée, de telle sorte que la saillie (25) est réalisée légèrement en forme d'entonnoir.

2. Boîtier (10) pour un dispositif électronique selon la revendication 1, **caractérisé en ce que** l'au moins un cylindre de protection (22) est associé à la partie de boîtier (12), en particulier **en ce que** l'au moins un cylindre de protection (22) est intégré dans la partie de boîtier (12) et le cylindre de protection (22) est réalisé sous forme de cylindre creux.

3. Boîtier (10) pour un dispositif électronique selon l'une des revendications précédentes, **caractérisé en ce que** la saillie (25) de la douille (24) forme une surface d'appui par rapport à une paroi intérieure (26) du cylindre de protection (22) et cette surface d'appui est de préférence biseautée.

4. Boîtier (10) pour un dispositif électronique selon l'une des revendications précédentes, **caractérisé en ce que** les moyens de liaison sont des vis (20), en particulier des rivets, des goupilles, des boulons ou similaires qui peuvent être vissés sur l'alésage (21), de préférence sur un alésage taraudé.

5. Boîtier (10) pour un dispositif électronique selon l'une des revendications précédentes, **caractérisé en ce que**, pour la liaison de la partie de boîtier (12) à la plaque de base (11), l'au moins une vis (20) peut être insérée à travers le cylindre de protection (22) et la douille (24) et peut être vissée dans l'alésage (21) de la plaque de base (11), en particulier la vis (20) peut être vissée contre la surface d'appui de la douille (24).

6. Boîtier (10) pour un dispositif électronique selon l'une des revendications précédentes, **caractérisé en ce que** le cylindre de protection (22) peut être recouvert par un joint d'étanchéité, par un scellement ou par le couvercle de boîtier (13).

7. Boîtier (10) pour un dispositif électronique selon l'une des revendications précédentes, **caractérisé en ce que** plusieurs cylindres de protection (22) comprenant des douilles (24) sont associés à la partie de boîtier (12), de préférence un cylindre de protection (22) doté d'une douille (24) est associé à chaque coin de la partie de boîtier (12).

8. Boîtier (10) pour un dispositif électronique selon l'une des revendications précédentes, **caractérisé en ce que** la plaque de base (11) et/ou la partie de boîtier (12) et/ou le couvercle de boîtier (13) comprend/comprennent une nervure périphérique (19, 28) et/ou une rainure d'étanchéité (18, 29), afin de relier la plaque de base (11) à la partie de boîtier (12) et/ou la partie de boîtier (12) au couvercle de boîtier (13), en particulier afin de les fermer.
